# EUROPEAN PATENT APPLICATION

(11) **EP 2 306 516 A1**
(43) Date of publication of application: **06.04.2011**
(21) Application number: 09012416.5
(22) Date of filing: 30.09.2009
(51) Int. Cl.: H01L 23/498, H01L 23/24, H01L 23/31

(54) **Semiconductor device, method for fabricating a semiconductor device and lead frame, comprising a bent contact section**

(71) Applicant: Tyco Electronics Nederland B.V., 5222 AR 's-Hertogenbosch (NL)
(72) Inventor: Jaeger, Peter Dirk, 4271 BP Dussen (NL)
(74) Representative: Grünecker, Kinkeldey, Stockmair & Schwanhäusser Anwaltssozietät

(57) **Abstract**

The present invention relates to a semiconductor device comprising an integrated circuit die and a housing (122) comprising a base surface and at least one lateral surface which extends across to the base surface. In particular, this semiconductor device can be an electronic chip card, such as a universal integrated circuit card, UICC. The present invention also relates to a method for fabricating such a semiconductor device and to a lead frame for mounting an integrated circuit die. According to the present invention, at least one electrical contact element (104) is provided for electrically connecting the integrated circuit die (124) with an abutting counter contact (142), wherein said electrical contact element (104) has first and second mating sections (108, 110) which are arranged on said base surface (102) and lateral surface (106), respectively, and are connected to each other via a bent section (112).

## Description

The present invention relates to a semiconductor device comprising an integrated circuit die and a housing comprising a base surface and at least one lateral surface which extends across to the base surface. In particular, this semiconductor device can be an electronic chip card, such as a universal integrated circuit card, UICC. The present invention also relates to a method for fabricating such a semiconductor device and to a lead frame for mounting an integrated circuit die.

Electronic chip cards such as integrated circuit cards have been constantly developed and improved in the past years. In particular, their form factor was adapted to the new market requirements so that the overall dimensions of an electronic card in use today could be reduced, for instance, down to 12 mm x 15 mm for a mini UICC. So called micro UICC have a form factor of 5 mm x 6 mm x 0,85 mm. These cards can include memory circuits and control circuits and can be easily integrated in small size devices or electronic circuitry such as the onboard system of a car or a machine for performing dedicated tasks.

A possible application for electronic cards is the automatic exchange of information between two or more end devices in order to allow remote monitoring, control or maintenance of machines or systems. In general, electronic cards with reduced dimensions are widely used in all kinds of so called machine to machine applications. Furthermore, it is known to use cards in mobile telephones, personal digital assistants, radio modems, and radio modules according to the GSM mobile standard (global system for mobile communication) or the UMTS mobile standard (universal mobile telecommunications system) in order to identify the user of the mobile terminal within the mobile net. These chip cards are plugged into the user equipment in order to read out the data stored thereon.

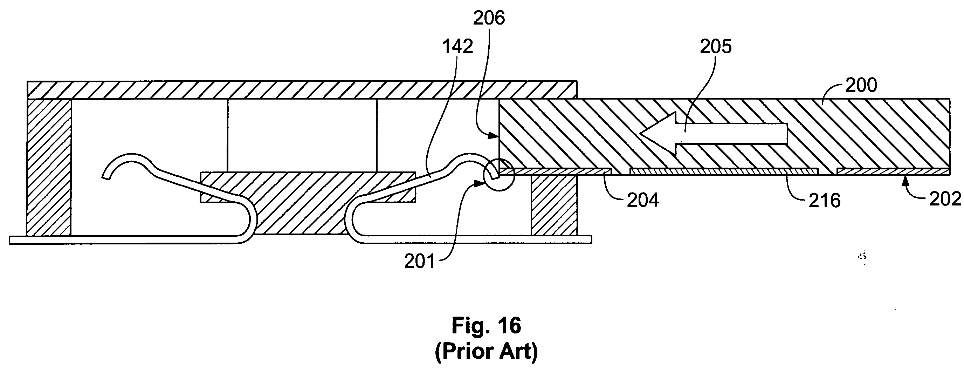

Figure 16 shows a slide-in connecting device for connecting a known UICC 200 fabricated by a conventional laminate frame, a so called lamframe, process to internal contacts 142 of the user equipment. As shown schematically in Figure 16, the electric contact elements 204 of the UICC 200 are arranged on a base surface 202 of the card housing and present sharp edges 201 to the device contact 142. These sharp edges in region 201 with current lamframe layouts result from performing the cutting step on the outside of the separated chip cards. They may lead to connector contact wear and also to corrosion, causing connection reliability problems.

Furthermore, the package of the conventional chip card 200 is fabricated by overmolding a plated metal strip and then separating these contacts by cutting same. In a next fabrication step, the integrated circuit die is placed and wired bonded and, finally, a second overmold closes the package, but leaves open the contact elements 204. As can be seen from Figure 16, at the edge 201, the contact 204 is not only very sharp, but also is not covered by the gold plating step, because the cutting is performed after plating the contact elements; therefore corrosion may occur in the region 201.

Generally, a number of different requirements have to be complied with by chip cards, depending on the particular field of application:

### Modem:

- Industrial environment, i.e. requires IP20 dust protection
- Compliance with higher operating temperatures
- Automatic pick and place

### Localization:

- Size is important
- Alternative connector application styles

### Automotive:

- Application in life saving equipment requires main focus on reliability
- Harsh environment (vibration and shock)

Consequently, a semiconductor device, in particular, a chip card and a belonging method of fabrication is needed, which improves the quality, stability and reliability of electrical connection to counter contacts of an electronic device.

This object is solved by the subject matter of the independent claims. Advantageous embodiments of the present invention are the subject matter of the dependent claims.

The present invention is based on (but not limited to) the idea of overmolding a stamped strip instead of the known laminated strips, the so-called lamframes. In particular, according to the present invention, the electrical contact element has first and second mating surfaces arranged on the base surface and the lateral surface, respectively, of the housing and are connected to each other via a bent section, which can be curved to form a radius, but can also have any other suitable shape, such as a combination of two 45° bends with a short straight portion there between. Further, the bent region can result in an essentially perpendicular arrangement of the first and second mating surfaces with respect to each other, but also to any other angle between the first and second mating surfaces. For instance, by bending the electrical contact element further than 90°, the inventive semiconductor device can be held in place when mounted within a module not only by the friction forces generated at the counter contact, but also by form fit. The combination of friction locking and form fit can result in a more stable mounting. In particular, the bent region is configured as a continuous region, such that the cross-over between the first and second mating sections is a smooth cross-over with no discontinuous formations. Accordingly, by providing a continuous cross-over the formation of a sharp-edge between said first and second mating sections is avoided. The advantage thereof is among others an increased reliability, since the wear of a chip or counter contact can be reduced.

By providing a connection surface on the bottom as well as on the side of the housing, and by providing a full radius there between, in the case of slide-in contacting, minimal wear can be achieved. Furthermore, the contact edges can also be covered with a metal plating and therefore the reliability of the electric contact is enhanced considerably. Additionally, many different mating directions and contacting schemes are possible. Finally, a higher reliability of the connection due to reduced tolerance chains can be achieved, when using the inventive chip card in sockets with contacts mating on the side contacts of the chip card's package.

A particularly well established, reliable and cost effective technique for fabricating the contact elements according to the present invention is a stamping and bending process from metal sheets. This technique is also compatible with reel to reel processes which can be fully automated.

The semiconductor device may further comprise at least one insulating element for mechanically securing and electrically insulating the at least one contact element. This insulating element can be fabricated in a particularly and easy cost effective way by overmolding the at least one contact element.

According to an advantageous embodiment, the integrated circuit die is attached to a die attach pad which in the fully assembled state is electrically insulated from the contact element. The die is fixed to the die attach pad by known techniques such as gluing, soldering or the like.

For some applications it may be useful to form the back side of the die attach pad which is opposite the mounting surface, as a cooling surface which extends outside the housing and is adapted to dissipate heat generated by the integrated circuit die.

According to an advantageous embodiment of the present invention, the housing comprises an electrically insulating cover for protecting and electrically insulating the integrated circuit die. This cover can for instance be formed by a further overmolding process. In case that the semiconductor device is directly soldered to a printed circuit board (PCB), the cooling surface can also be soldered to copper surfaces on the PCB which provide heat sink function.

The foregoing and other features of the present invention will now be described with reference to the accompanying drawings. In the drawings, the same components have the same reference numerals. The drawings are incorporated into and form a part of the specification for the purpose of explaining the principles of the invention. However, the drawings are not to be construed as limiting the invention to only the illustrated and described examples of how the invention can be used and made. Moreover, different aspects and details of the embodiments explained in the following may form inventive solutions in alternative combinations or arrangements. Further features and advantages will become apparent from the following and more detailed description of the invention which is illustrated in the accompanying drawings, wherein:
- **Figure 1**: shows a perspective view of a base surface of a chip card according to the present invention in the fully assembled state;
- **Figure 2**: shows a perspective view of the chip card of Figure 1 turned by 180°;
- **Figure 3**: shows a perspective, partly opened view of the chip card of Figure 2;
- **Figure 4**: shows a lead frame according to the present invention in a first fabrication state;
- **Figure 5**: shows the lead frame of Figure 4 after bending the contact elements;
- **Figure 6**: shows the lead frame after providing the insulation elements that support and insulate the contact elements;
- **Figure 7**: shows the lead frame after punching the slots that separate the contact elements from each other and from the die attach pad;
- **Figure 8**: shows the lead frame after attaching the integrated circuit die;
- **Figure 9**: shows the lead frame after providing the wire bond connections between the integrated circuit die and the contact elements;
- **Figure 10**: shows a second embodiment of a lead frame according to the present invention;
- **Figure 11**: shows a perspective view onto a chip card according to a third embodiment of the present invention;
- **Figure 12**: shows the arrangement of Figure 11 turned by 180°;
- **Figure 13**: shows a perspective view of the chip card of Figure 12 in a partly opened view;
- **Figure 14**: shows a sectional view of a first electrical contacting scheme for the inventive chip card;
- **Figure 15**: shows a sectional view of the second contacting scheme for the inventive chip card;
- **Figure 16**: shows schematically the contacting process of a conventional chip card with a slide-in counter contact.

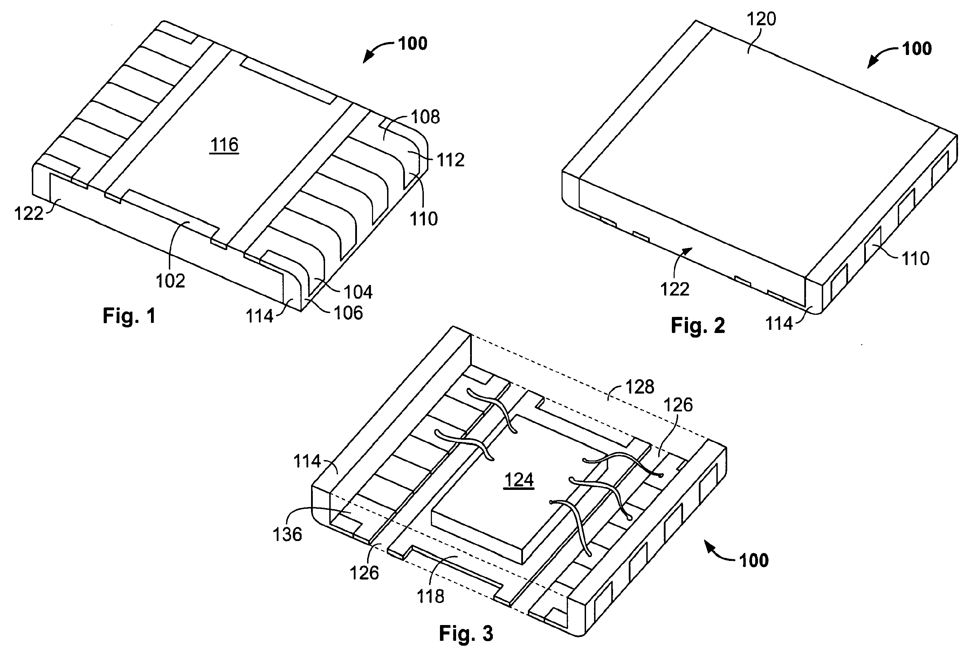

Figure 1 shows in a perspective view a micro universal integrated circuit card, UICC, 100 according to the present invention. Of course, the inventive concept can be used with any other integrated circuit package which is intended to be brought into contact with belonging contacts or to be soldered to a substrate. The UICC 100 is shown in Figure 1 with the contact carrying base surface 102 facing upward in order to illustrate more clearly the contact elements 104. According to the present invention, the contact elements 104 comprise first mating sections 108 which are in plane with the base surface 102, and second mating sections 110 which extend across to the first mating sections 108 and are arranged at the lateral surface 106.

A bent section 112 connects the two mating sections 108, 110 to each other. According to the shown embodiment, this bent section is formed as a curved section, in particular as a complete radius. Such radius contact allows for slide-in application contacting with minimal wear. However, the inventive bent section 112 can also have any other suitable shape, such as a combination of two 45° bends with a short straight portion there between. Further, the bent region here results in an essentially perpendicular arrangement of the first and second mating surfaces 108, 110 with respect to each other, but any other angle between the first and second mating surfaces can also be formed according to the present invention. As is clear from Figure 1, the bent section 112 is a smooth bent section with no discontinuous formations, thereby forming a cross-over between the first and second mating surfaces 108, 110 free of a sharp edge.

As will become more apparent from Figure 3, the contact elements 104 are electrically insulated from each other and mechanically supported by an insulating element 114. The insulating element 114 can for instance be fabricated by an injection molding step.

A cooling surface 116 of a die attach pad 118 extends to the outside of the semiconductor device 100 in order to operate as a heat sink. In the case that the micro UICC 100 is directly soldered for instance to a printed circuit board, PCB, the cooling surface 116 can be soldered to a belonging copper surface of the printed circuit board to provide a heat sink function and quickly dissipate heat generated by the integrated circuit die.

Figure 2 shows the UICC 100 of Figure 1 turned by 180°. As can be seen from this Figure, a cover 120 closes the housing 122. This cover is for instance formed by a plastic material that is overmolded in order to tightly close the housing. As the surface of the cover 120 is completely smooth, it offers the advantage of representing a relatively large and well-defined pick-and-place area for an automatic placement machine.

In Figure 3, the UICC 100 is shown without the material of the cover 120 in order to explain the inner structure of the UICC. On the inside of the housing 122, the integrated circuit die 124 is attached to the die attach pad 118. The electrical connections between the integrated circuit die 124 and bond pads 136 of the contact elements 104 can for instance be established by means of wire bonding. As will be apparent from the description of the fabricating steps in the following, small, sharp edges which result from cutting and stamping processes at the metal lead frame are either completely covered by the cover material 120 as this is the case with the insulating sections 126 between the contact elements 104 and the die attach pad 118. Alternatively, sharp edges are only to be found on surfaces which are not critical for electrical connections, such as the second lateral surfaces 128.

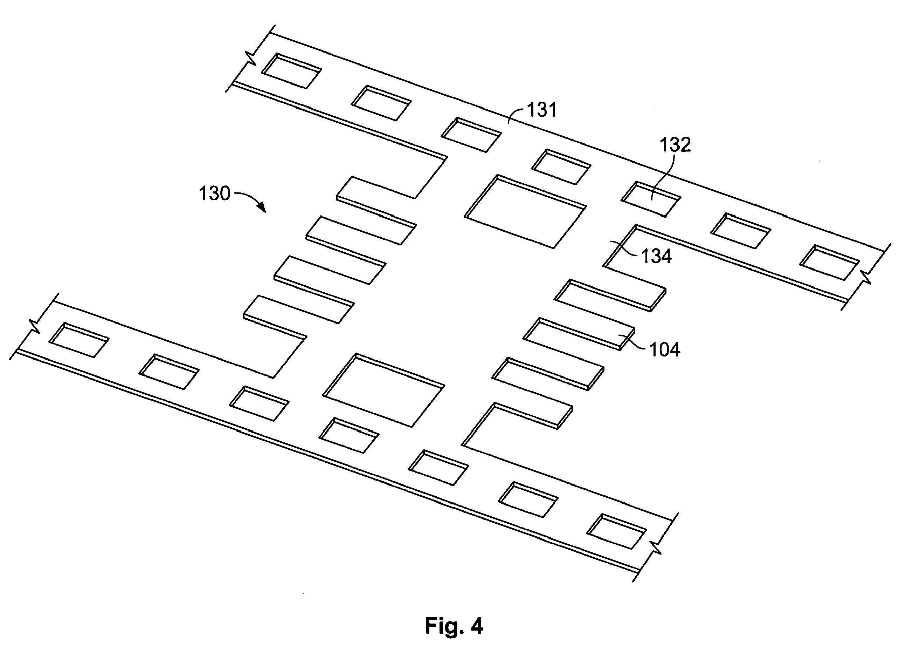

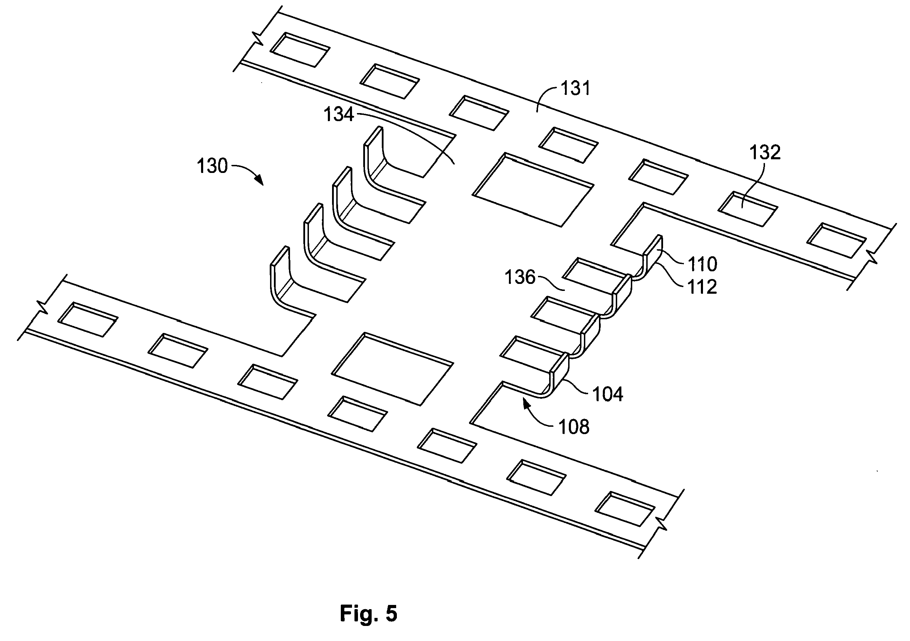

With reference to Figures 4 to 9, the fabrication process of a lead frame 130, which can be separated into semiconductor devices according to the present invention will be explained in detail. Lead frame 130 is part of a carrier strip in a reel-to-reel process suitable for fully automated manufacturing. As shown in Figure 4, a first stamping process is performed to provide the contact elements 104 and further provide web elements 134 for fixing the lead frame on the carrier 131 of the strip. Sprocket holes 132 are provided for the processing in a reel-to-reel process, as this known to a person skilled in the art.

Next, a bending step follows which provides the curved section 112 and forms the contact elements 104 to have two mating sections 108 and 110 which extend across to each other. However, any other profiles of the bent section 112 can also be fabricated during this step. After the forming step, the mating surfaces of the contact elements can be plated with an electrically conductive and corrosion stable film, such as gold. Of course, all usual deposition techniques and materials for forming such a plating layer can be applied. The bending process also has the advantage that a selective galvanic plating process can be performed.

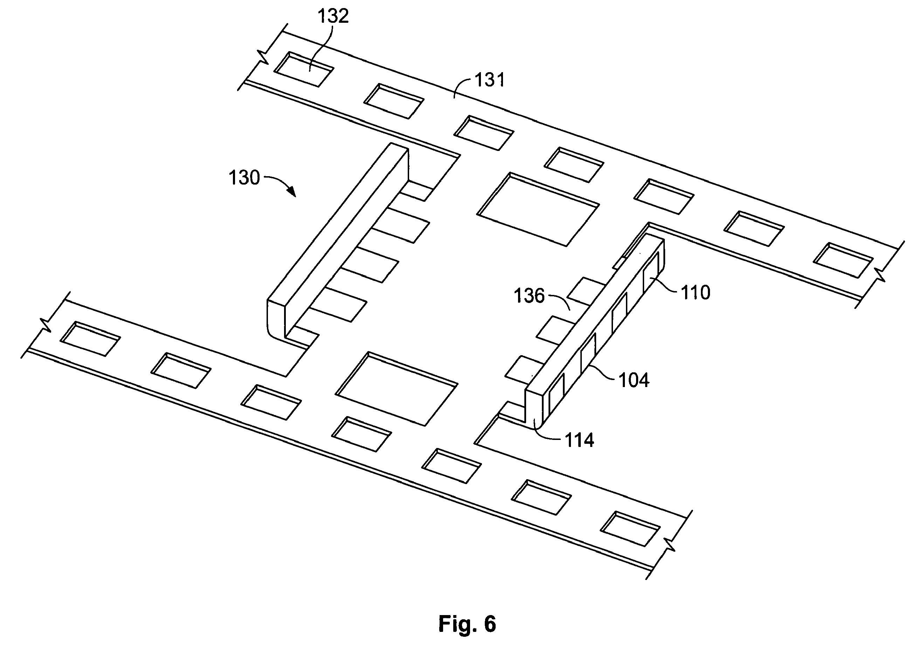

Figure 6 shows the lead frame 130 after a first overmolding step wherein the insulating elements 114 are formed. The contact elements 104 together with their radius are embedded and supported in the material of the insulating element 114 during this overmolding step.

Subsequently, a further punching step can be performed in order to separate from each other the contact elements 104 which are mechanically fixed within the insulating element 114. The stamped slots forms the insulating section 126 between the die attach pad 118 and the contact elements 104 in the finally mounted state.

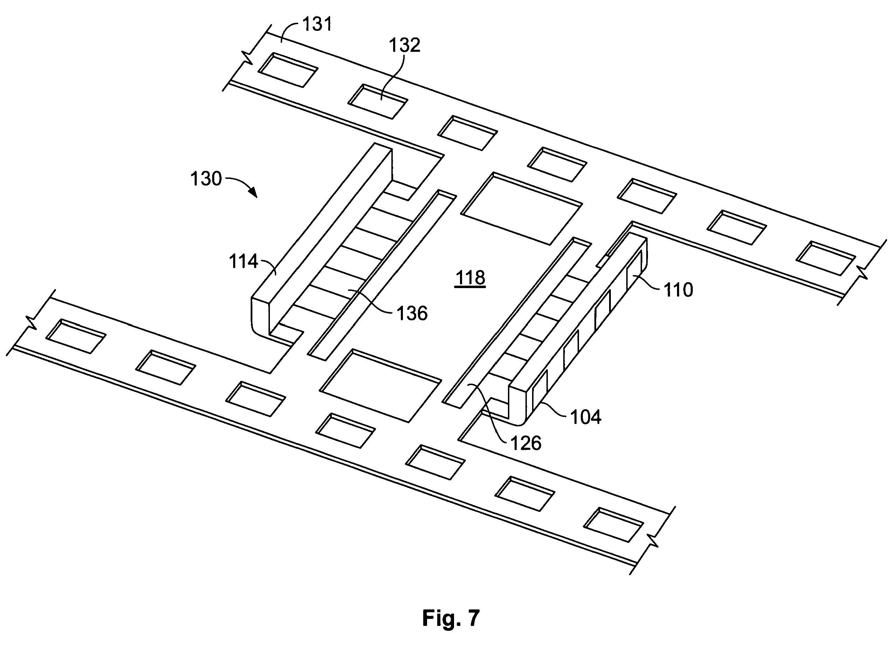

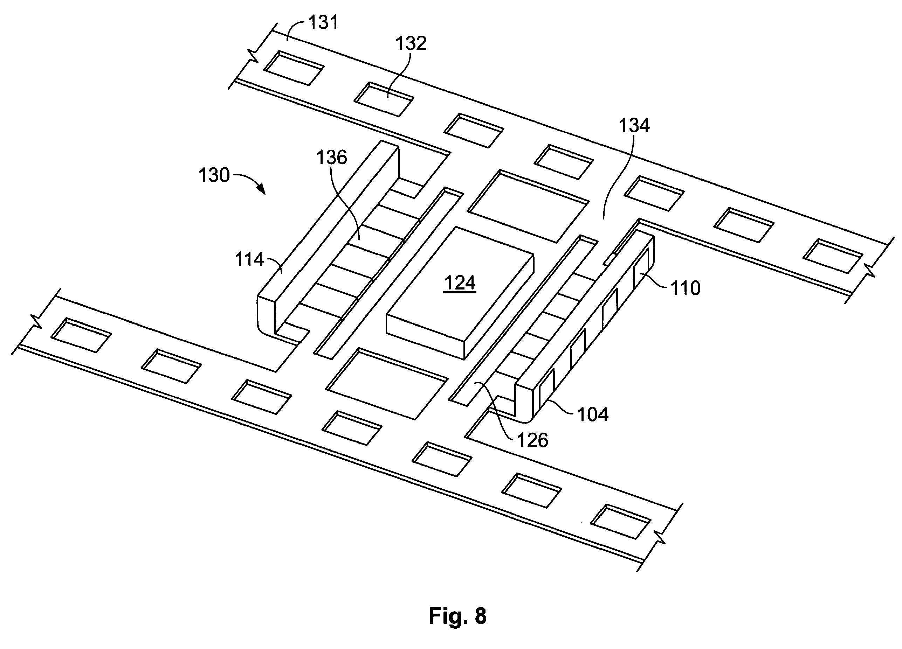

By conventional die attaching techniques the integrated circuit die 124 can now be attached to the die attach pad 118 as can be seen from Figure 8. However, the carrier strips without the integrated circuit die 124 assembled thereon can also be kept on stock and transferred to a customer in the form they have in Figure 7.

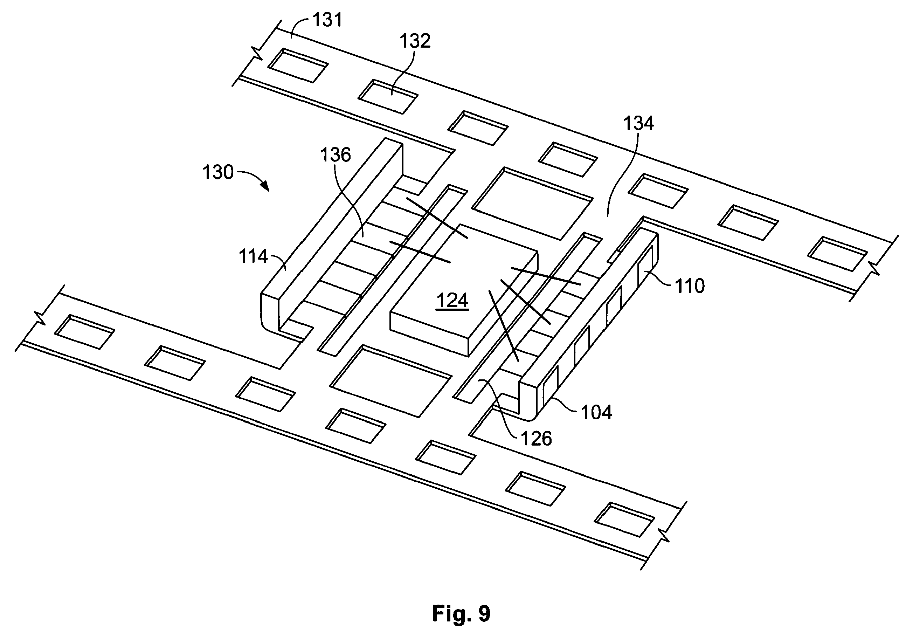

A wire bonding step is performed to provide the electrical connection between the integrated circuit die 124 and bond pads 136 of the contact elements. The result of this step is depicted in Figure 9.

Before the webs 134 are cut and the semiconductor devices are separated, thereby forming the individual UICCs 100, the cover 120 is added which is shown in Figures 1 and 2. The cover can be produced by a second overmolding step or by potting, filling or encapsulation steps, or by mounting a cover. This assembly step can also be performed by a customer.

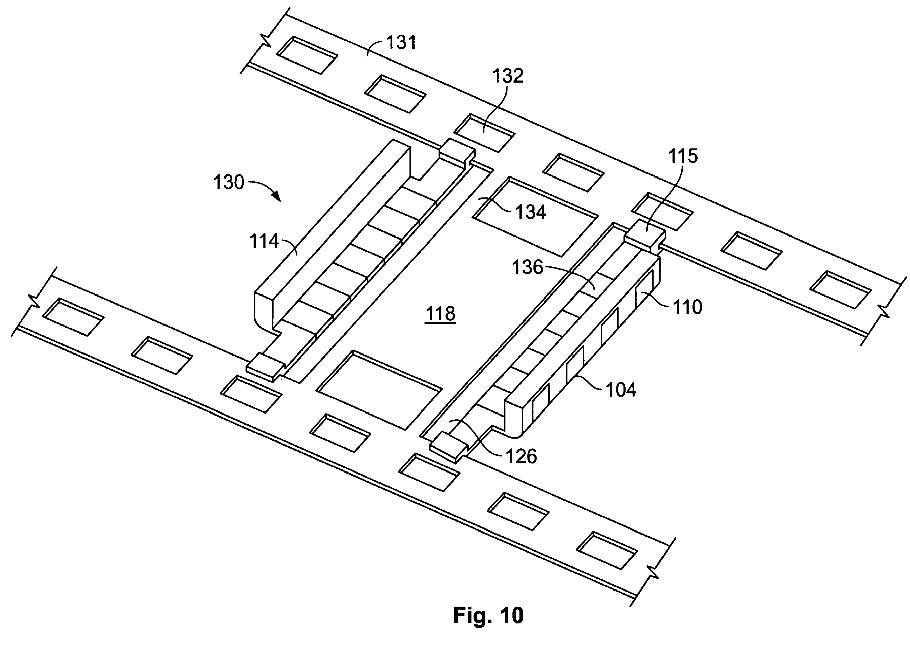

Figure 10 shows another embodiment of a lead frame structure according to the present invention, where, instead of the metallic webs that establish an electrical contact between the outside carrier 131 and the contact elements 104, a non-conductive link 115 to the strip is provided by mounting the contact elements as a separate part embedded within the insulating element 114. This embodiment can replace the embodiment of Figure 7 and has the advantage that due to the non-conductive fixing means 115, after attaching the integrated circuit die 124 and performing the wire bonding process, a test of the electrical connections between the bond pads and the integrated circuit die 124 can be effected already on the strip without the necessity of isolating the individual semiconductor devices by cutting them apart.

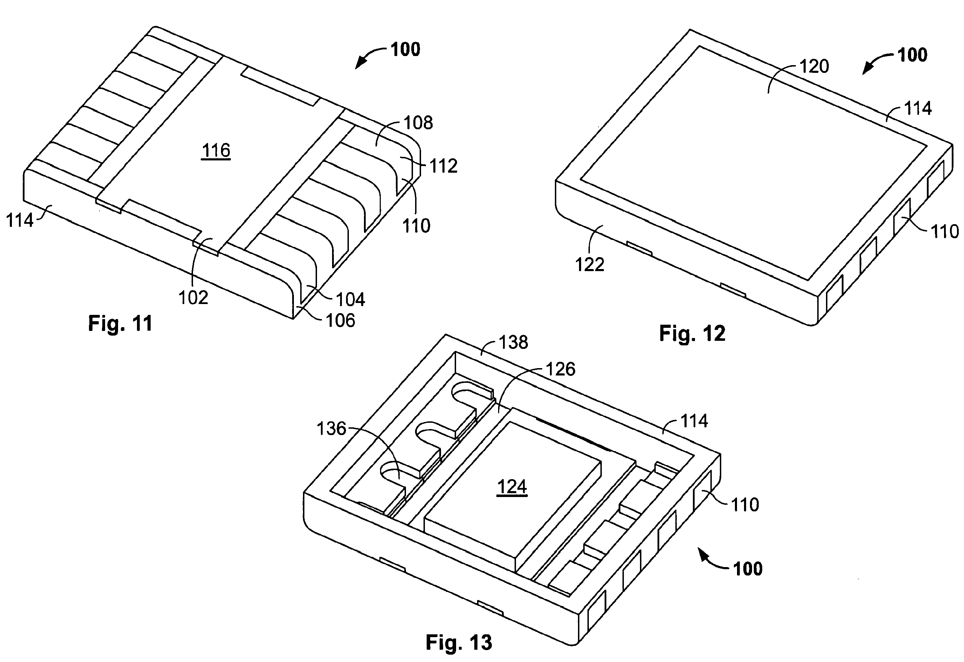

Still another advantageous embodiment is shown in Figures 11 to 13. Here, the insulating elements 114 are formed as a frame 138 which encompasses the integrated circuit die 124. Such circumferentially closed insulating frame has the advantage that the potting or overmolding process for providing the cover 120 is facilitated.

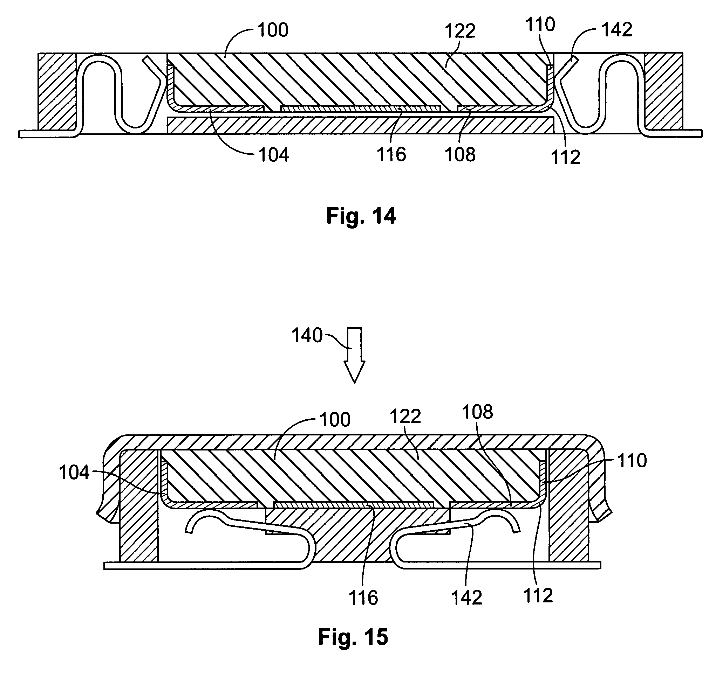

Figures 14 and 15 show two possible electrical contacting schemes for the inventive UICC 100.

As can be seen from Figure 14, the second mating section 110 on the lateral surface 106 allows for a contacting by means of a slide-in motion without the necessity of applying a residual pressure in a contacting direction 140. The UICC 100 is kept in position by the friction force on the contacts. When forming the bent section 112 in a way that the second mating section 110 on the lateral surface 106 is bent by more than 90° or to have a recess allowing the engagement of the counter contact 142, also a form fit can be achieved.

The tolerance chain of this arrangement is very short because only the sum of the tolerance of the UICC and of the distance between the contacts 142 has to be considered, whereby the reliability can be enhanced. Furthermore, this sort of contacting leads to a larger wipe area between the contact element 104 and the counter contact 142. A large wipe distance, however, is favorable because it cleans the contact point of any pollution. Furthermore, side contacts according to the present invention allow for an ultra low height socket and enhance the reliability of the electric contact. Side contacting schemes moreover allow a fully automated pick and place assembly of the semiconductor device.

Also with a press-in contact as shown in Figure 15, the UICC 100 according to the present invention can elegantly be used. This arrangement has the advantage that it allows for the smallest printed circuit board area design possible. In any case, the inventive side and bottom contacts enhance the design flexibility for a module designer.

In conclusion, the present invention which can, of course, be used for memory cards, smart cards, ID cards and socketable ICs offers the following main advantages: Firstly, the inventive solution allows for fully plated contact areas and makes sure that no bare base material of the lead frame is exposed. Further, many different mating directions and principles for the electrical contact to a counter contact are possible. In particular, electrical contact can be established via the two mating surfaces at the bottom and the side surface as well as via the radius of the contact.

Slide-in mating motions can be performed with minimal wear to the connector because sharp edges can be avoided. Finally, high reliability of the connections can be achieved due to reduced tolerance chain in sockets when using the contacts mating on the side contact of the UICC package.

### Reference Numeral List

| | |
|---|---|
| 100 | semiconductor device, in particular UICC |
| 200 | conventional semiconductor device, in particular UICC |
| 201 | region with sharp edges |
| 102 | base surface |
| 202 | conventional base surface |
| 104 | contact element |
| 204 | conventional contact element |
| 205 | direction of sliding motion |
| 106 | lateral surface |
| 206 | conventional lateral surface |
| 108 | first mating surface (on base surface) |
| 110 | second mating surface (on lateral surface) |
| 112 | bent section |
| 114 | insulating element |
| 115 | fixing means for fixing insulating element at carrier strip |
| 116 | cooling surface |
| 216 | conventional cooling surface |
| 118 | die attach pad |
| 120 | cover |
| 122 | housing |
| 124 | integrated circuit die |
| 126 | insulating section |
| 128 | second lateral surfaces |
| 130 | lead frame |
| 131 | carrier |
| 132 | sprocket hole |
| 134 | web |
| 136 | bond pad |
| 138 | frame |
| 140 | direction of contact pressure |
| 142 | counter contact |

## Claims

1. Semiconductor device comprising:
an integrated circuit die (124),
a housing (122) comprising a base surface (102) and at least one lateral surface (106) which extends across to said base surface;
at least one electrical contact element (104) for electrically connecting the integrated circuit die (124) with an abutting counter contact (142),
wherein said electrical contact element (104) has first and second mating sections (108, 110) which are arranged on said base surface (102) and lateral surface (106), respectively, and are connected to each other via a bent section (112).

2. Semiconductor device according to claim 1, wherein said at least one electrical contact element (104) is formed by a stamped and bent metal sheet.

3. Semiconductor device according to claim 1 or 2, wherein at least one of the first and second mating sections (108, 110) of the contact element (104) are plated with an electrically conductive layer.

4. Semiconductor device according to one of claims 1 to 3, further comprising at least one insulating element (114) for mechanically securing and electrically insulating the at least one contact element (104).

5. The contacting device according to claim 4, wherein the at least one insulating element (114) is formed by over-molding the at least one contact element (104).

6. Semiconductor device according to at least one of the preceding claims, further comprising a die attach pad (118) for attaching said integrated circuit die (124), wherein said die attach pad (118) is separated from the at least one contact element (104) by an insulating section (126).

7. Semiconductor device according to claim 7, wherein a cooling surface (116) of the die attach pad (118) which is opposite to a mounting surface whereto the die is attached, extends outside said housing (122) for dissipating heat generated by the integrated circuit die (124).

8. Semiconductor device according to at least one of the preceding claims, wherein said housing (122) comprises a cover (120) for protecting said integrated circuit die.

9. Semiconductor device according to claim 8, wherein the cover (120) is fabricated from an electrically insulating material.

10. Semiconductor device according to claim 8 or 9, wherein the cover (120) is fabricated by an over-molding process.

11. Semiconductor device according to at least one of the preceding claims, wherein said housing (122) has a substantially flat form, and wherein said semiconductor device comprises a plurality of contact elements which are arranged according to a Universal Integrated Circuit Card, UICC, standard.

12. Method for fabricating a semiconductor device, said method comprising the steps of:
fabricating a lead frame (130) comprising at least one electrical contact element (104) for electrically connecting an integrated circuit die (124) with an abutting counter contact (142), and comprising a die attach pad (118) for attaching said integrated circuit die;
forming a bent section (112) at the at least one contact element (104) by bending a stamped portion of said lead frame, wherein said bent section connects first and second mating sections (108, 110) of the at least one contact element, and wherein said first and second mating sections extend substantially across to each other.

13. Method of claim 12, further comprising the steps of:
providing at least one insulating element for mechanically securing and electrically insulating the at least one contact element;
stamping a slot for separating the at least one contact element from said die attach pad in a fully assembled state.

14. Method of claim 12 or 13, further comprising the step of:
attaching said integrated circuit die to the die attach pad and providing an electrical connection between the integrated circuit die and the at least one contact element.

15. Lead frame for mounting an integrated circuit die (124), said lead frame (130) comprising at least one electrical contact element (104) for electrically connecting the integrated circuit die (124) with an abutting counter contact (142), and comprising a die attach pad (118) for attaching said integrated circuit die (124),
wherein a bent section (112) is formed at the at least one contact element (104) by bending a stamped portion of said lead frame, wherein said bent section (112) connects first and second mating sections (108, 110) of the at least one contact element, and wherein said first and second mating sections (108, 110) extend substantially across to each other.
